# EUROPEAN PATENT SPECIFICATION

(11) **EP 4 415 042 B1**
(45) Date of publication and mention of the grant of the patent: **15.10.2025**
(21) Application number: 24154067.3
(22) Date of filing: 26.01.2024
(51) Int. Cl.: H01L 23/495, H01L 21/56

(54) **POWER LEADFRAME PACKAGE WITH LEAD SIDEWALL SURFACE THAT IS FULLY SOLDER WETTABLE**
LEISTUNGSRAHMENGEHÄUSE MIT LEITERSEITENWANDOBERFLÄCHE, DIE VOLLSTÄNDIG LÖTBENETZBAR IST
BOÎTIER DE GRILLE DE CONNEXION DE PUISSANCE AVEC SURFACE DE PAROI LATÉRALE DE CONDUCTEUR ENTIÈREMENT MOUILLABLE PAR SOUDURE

(30) Priority: 10.02.2023 US 202363444721 P; 17.01.2024 US 202418415006
(43) Date of publication of application: 14.08.2024
(73) Proprietor: STMicroelectronics International N.V., 1228 Plan-les-Ouates, Geneva (CH)
(72) Inventor: TALLEDO, Jefferson Sismundo, 4027 CALAMBA (PH)
(74) Representative: Casalonga

(56) References cited:
- WO-A1-2021/133420
- US-A1- 2012 292 755
- US-A1- 2018 269 147
- US-B1- 8 076 181

## Description

### TECHNICAL FIELD

The present invention generally relates to semiconductor packaging and, more particularly, to a power leadframe package with leads having sidewall surfaces that are fully solder wettable.

### BACKGROUND

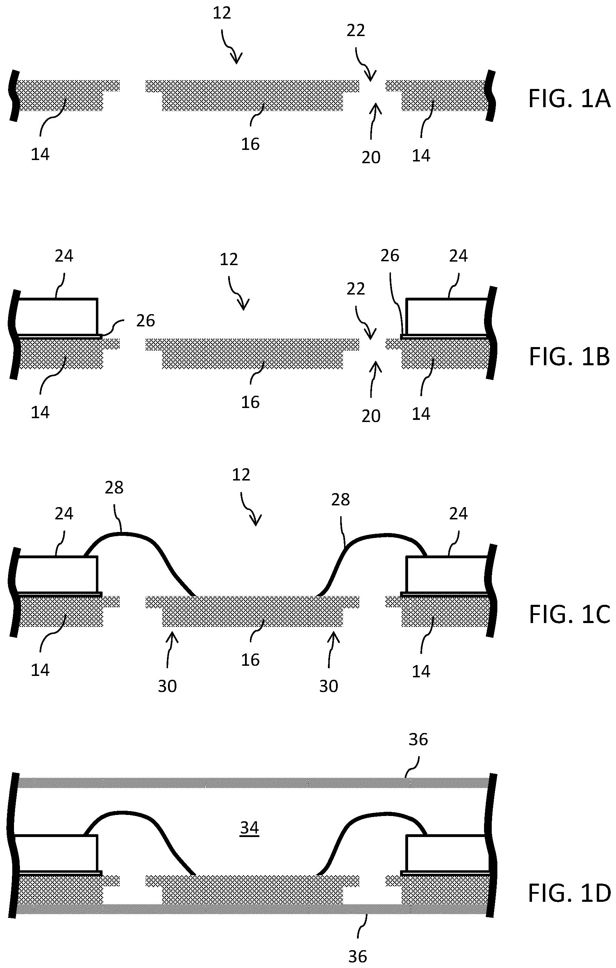

Reference is made to Figures 1A-1L which show steps of a manufacturing process for producing a power leadframe package for an integrated circuit power transistor device.

Figure 1A - provision is made from a manufacturer or supplier of an etched leadframe 12 that includes die pad portions 14 and lead portions 16. The die pad portions 14 and lead portions 16 are separated from each other by spaces defined by a half-etched opening 20 at the bottom of the leadframe and a through opening 22 at the top of the leadframe.

Figure 1B - an integrated circuit die 24 is mounted to the upper surface of each die pad portion 14. This attachment may, for example, be made using a suitable die attachment mechanism 26. As an example, a die attach film, a layer of adhesive, or a layer of solder could be used for attachment.

Figure 1C - bonding pads at an upper surface of the integrated circuit die 24 are electrically connected to upper surfaces at the distal ends 30 of the lead portions 16 of the leadframe 12 by bonding wires 28.

Figure 1D - the assembly of the leadframe 12, integrated circuit dies 24 and bonding wires 28 is then positioned within the open cavity 34 of a mold 36.

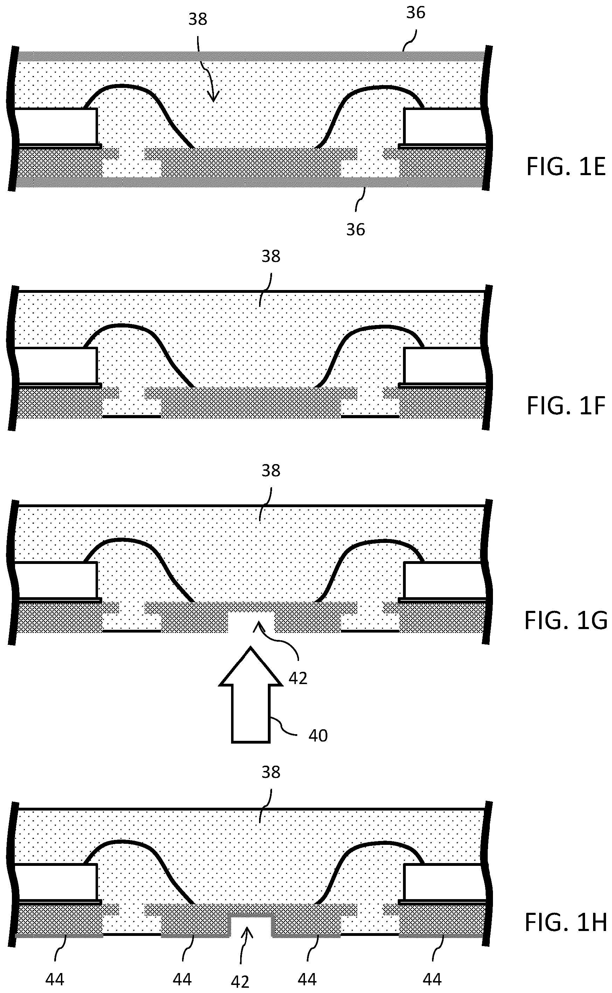

Figure 1E - a resin encapsulant material is injected into the open cavity 34 and cured to form an encapsulating body 38 that encapsulates the assembly of the leadframe 12, integrated circuit dies 24 and bonding wires 28, including filling the half-etched openings 20 and through openings 22 of the leadframe 12.

Figure 1F - the encapsulated assembly is removed from the mold 36.

Figure 1G - a saw (schematically represented by arrow 40) is used to partially cut through the lead portions 16 of the leadframe 12 to form a channel 42. The depth of the channel 42 may, for example, comprise between 40 and 60 percent of the overall thickness of the lead portions 16 of the leadframe 12.

Figure 1H - an electroless plating process is then performed to plate a tin layer 44 on the exposed surfaces of the leadframe 12. These exposed surfaces would include, for example, the lower surfaces of the die pad portions 14 of the leadframe 12, the lower surfaces of the lead portions 16 of the leadframe 12, and the sidewalls and bottom of the channel 42 formed in the lead portions 16 of the leadframe 12.

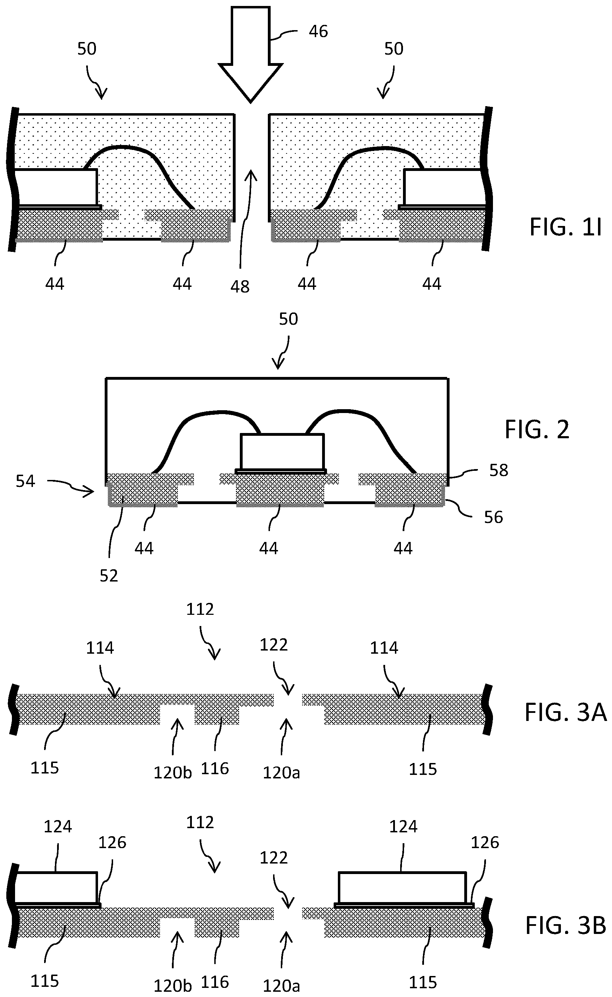

Figure 1I - a saw (schematically represented by arrow 46) is used to completely cut through the encapsulated assembly and form a separation opening 48. This saw cut is aligned with the location of the saw cut which formed the channel 42. This cutting operation effectuates a singulation of the encapsulated assembly into a plurality of power leadframe packages 50. A width of the saw cut performed by saw 46 is smaller than a width of the saw cut performed by saw 40.

Figure 2 shows a cross-sectional view of the power leadframe package 50. It will be noted that the flank area 54 of the leads 52 (i.e., their sidewall surfaces) for the power leadframe package 50 includes a wettable flank portion 56 (covered by the tin layer 44) and a non-wettable flank portion 58 (exposed by the saw cut in the step shown in Figure 1I). As a result, this power leadframe package 50 does not present a fully-wettable sidewall for the package leads 52.

There is a need in the art to address this deficiency and provide a power leadframe package with leads having sidewall surfaces that are fully solder wettable. Documents US2018/269147 A1, US2012/292755A1, US8076181 B1 and WO2021/133420 A1 disclose prior art.

### SUMMARY

In an embodiment, a method comprises: providing an etched leadframe that includes a plurality of frame portions, wherein the frame portions are separated from each other by spaces, and wherein each frame portion includes an intermediate region interposed between a lead region and a die pad region; mounting an integrated circuit die to an upper surface of each frame portion at said die pad region; mounting a chip mounting portion of a metal clip to each integrated circuit die, said metal clip further including a lead mounting portion mounted to the lead region of an adjacent frame portion, and said metal clip still further including a bridge portion extending over said intermediate region of said adjacent frame portion and mounted to the die pad region of said adjacent frame portion; performing a first operation to cut through the frame portion of each etched leadframe at said intermediate region to separate the lead region and die pad region without severing the bridge portion of each metal clip; plating a conductive layer on full sidewalls of the lead region and die pad region exposed by the first operation to cut; and performing a second operation to cut through the bridge portion of each metal clip.

In an embodiment, a power leadframe integrated circuit package comprises: a leadframe including a lead region and a die pad region separated by a space; an integrated circuit die mounted to an upper surface of the die pad region; a first metal clip having a chip mounting portion mounted to the integrated circuit die, said first metal clip further including a lead mounting portion mounted to the lead region and a first residual bridge portion; a second metal clip including a second residual bridge portion mounted to the die pad region; an encapsulating body encapsulating the leadframe, the integrated circuit die and the first and second metal clips; wherein said encapsulating body has a first peripheral sidewall at which an end of said first residual bridge portion is exposed and has a second peripheral sidewall, opposite said first peripheral sidewall, at which an end of said second residual bridge portion is exposed; wherein a sidewall of the lead region is exposed at said first peripheral sidewall of the encapsulating body, and wherein a sidewall of the die pad region is exposed at said second peripheral sidewall of the encapsulating body; and a plating layer on all of said sidewall of the lead region and all of said sidewall of the die pad region.

### BRIEF DESCRIPTION OF THE DRAWINGS

For a better understanding of the embodiments, reference will now be made by way of example only to the accompanying figures in which:
Figures 1A-1I show steps of a manufacturing process for producing a power leadframe package for an integrated circuit power transistor device;
Figure 2 shows a power leadframe package produced by the process of Figures 1A-1L;
Figures 3A-3I show steps of a manufacturing process for producing a power leadframe package for an integrated circuit power transistor device;
Figure 4 shows a power leadframe package produced by the process of Figures 3A-3L;
Figures 5A-5D show top views at the stage of the manufacturing process shown at steps corresponding to Figures 3A, 3B, 3C and 3I, respectively; and
Figure 6 is a perspective view of an assembly of a leadframe, integrated circuit die and clip at the stage of the manufacturing process shown at the step corresponding to Figure 3C.

### DETAILED DESCRIPTION

Reference is made to Figures 3A-3I which show steps of a manufacturing process for producing a power leadframe package for an integrated circuit power transistor device.

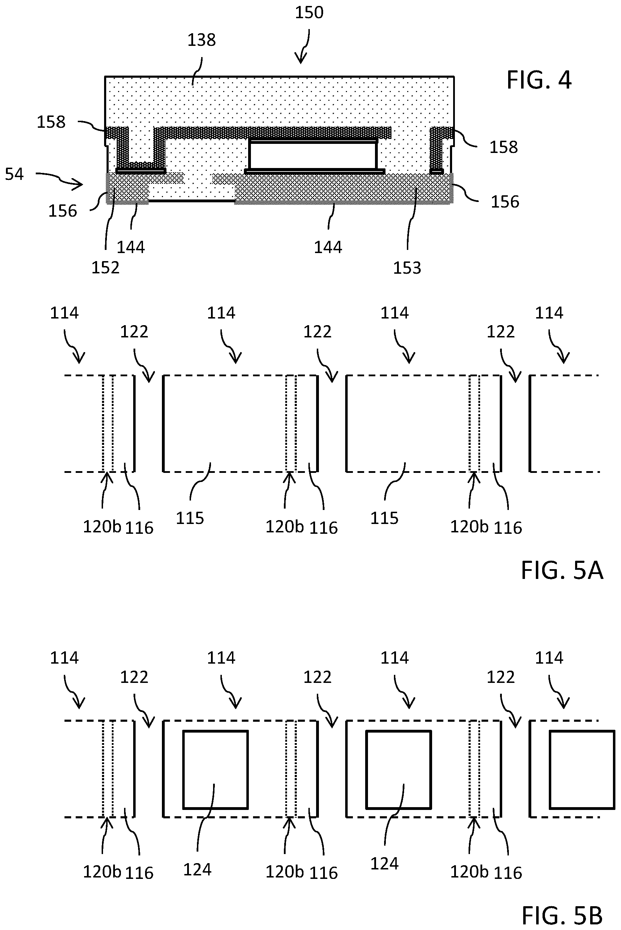

Figure 3A - provision is made from a manufacturer or supplier of an etched leadframe 112 that includes frame portions 114. The frame portions 114 are separated from each other by spaces defined by a half-etched opening 120a at the bottom of the leadframe and a through opening 122 at the top of the leadframe. A further half-etched opening 120b at the bottom of the leadframe is optionally provided at an intermediate region (of each frame portion 114) located between a die pad region 115 and lead region 116 of each frame portion 114. It will be noted, however, that the optionally provided further half-etched opening 120b does not separate the die pad region 115 and lead region 116. Figure 5A shows a top view of a portion of the leadframe 112 at the stage of the manufacturing process shown in Figure 3A.

Figure 3B - an integrated circuit die 124 is mounted to the upper surface of each frame portion 114 at the die pad region 115. This attachment may, for example, be made using a suitable die attachment mechanism 126. As an example, a die attach film, a layer of adhesive, or a layer of solder could be used for attachment. Figure 5B shows a top view of a portion of the leadframe 112 with attached integrated circuit dies 124 at the stage of the manufacturing process shown in Figure 3B.

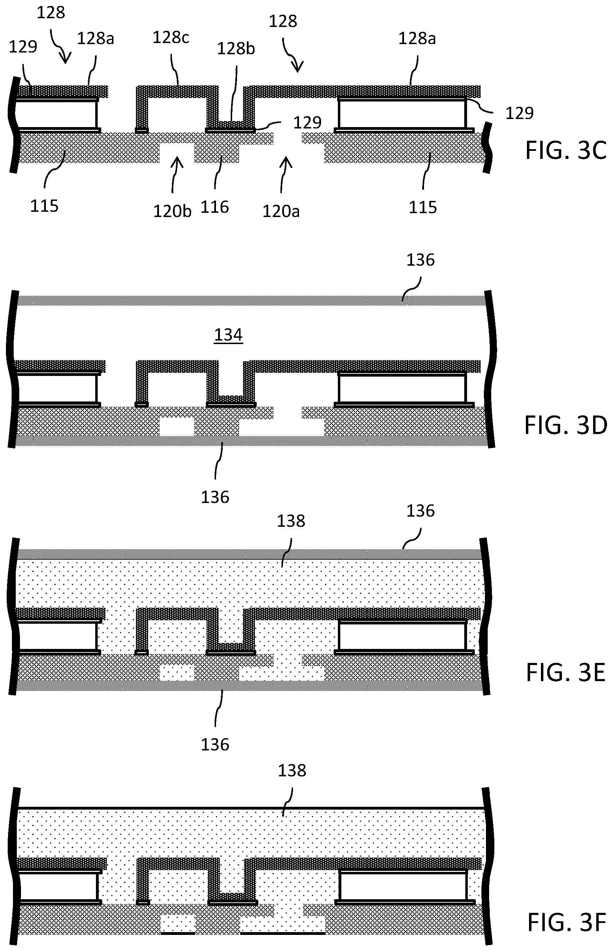

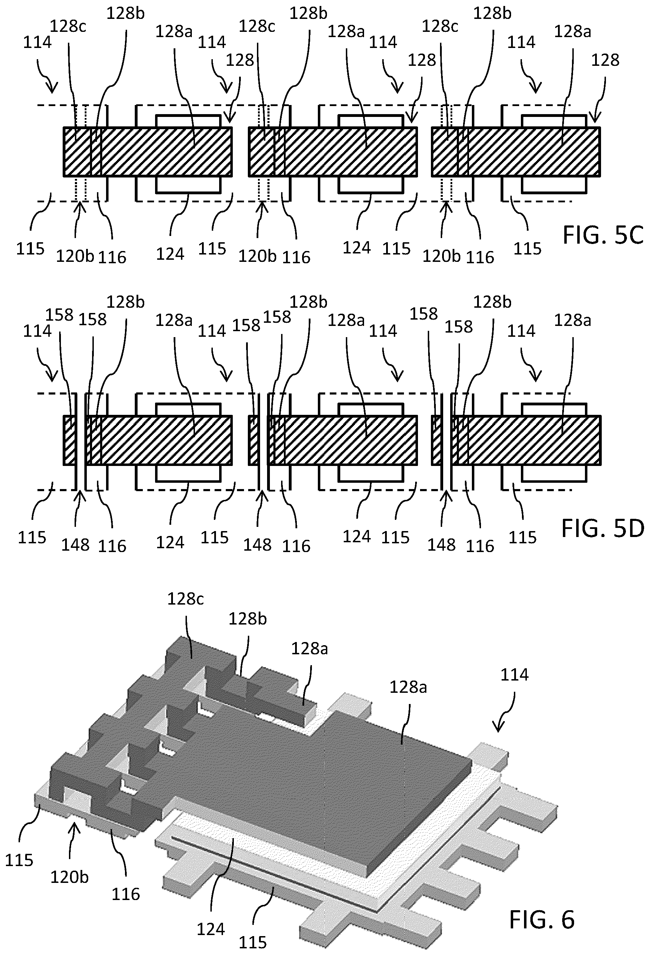

Figure 3C - bonding pads at an upper surface of the integrated circuit die 124 mounted to the die pad region 115 of one frame portion (for example, portion 114a) of the lead frame 112 are electrically connected to upper surfaces at the lead regions 116 of an adjacent frame portion (for example, portion 114b) of the leadframe 112 and further to the die pad region 115 of that adjacent frame portion 114b of the leadframe 112 using a metal clip 128. The metal clip 128 comprises a strip of material that is bent into a shape that includes a chip mounting portion 128a, a lead mounting portion 128b and a bridge portion 128c. The chip mounting portion 128a is essentially a flat portion having a lower surface that is electrically connected by a solder material 129 to bonding pads of the integrated circuit die 124. The lead mounting portion 128b is essentially an L-shaped portion having a vertical leg and a horizontal leg; where the vertical leg extends downwardly from the chip mounting portion 128a towards the leadframe 112 and the horizontal leg has a lower surface that is electrically connected by a solder material 129 to the upper surface at the lead region 116 of the adjacent frame portion 114b of the leadframe 112. The bridge portion 128c is essentially an upside-down U-shaped portion having a first vertical leg, a horizontal leg and a second vertical leg; where the first vertical leg extends upwardly from the horizontal leg of the lead mounting portion 128b, the horizontal leg extends from the first vertical leg to bridge over the location of the further half-etched opening 120b, and the second vertical leg extends downwardly from the horizontal leg and has an end surface electrically connected by a solder material 129 to the upper surface at the die pad region 115 of the adjacent frame portion 114b of the leadframe 112. Figure 5C shows a top view of a portion of the leadframe 112 with attached integrated circuit dies 124 and mounted metal clips 128 at the stage of the manufacturing process shown in Figure 3C. Figure 6 shows a perspective view of an assembly of the leadframe 112, integrated circuit die 124 and clip 128 at the stage of the manufacturing process shown in Figure 3C.

It will be noted that other bonding pads of the integrated circuit die 124 may be electrically connected to upper surfaces at the distal ends of the lead regions 116 of the leadframe 12 by bonding wires (not explicitly shown) or through use of one or more other clips 128 as shown in Figure 6.

Figure 3D - the assembly of the leadframe 112, integrated circuit dies 124 and clips 128 is then positioned within the open cavity 134 of a mold 136.

Figure 3E - a resin encapsulant material is injected into the open cavity 134 and cured to form an encapsulating body 138 that encapsulates the assembly of the leadframe 112, integrated circuit dies 124 and clips 128, including filling the half-etched openings 120a, 120b and through openings 122 of the leadframe 112.

Figure 3F - the encapsulated assembly is removed from the mold 136.

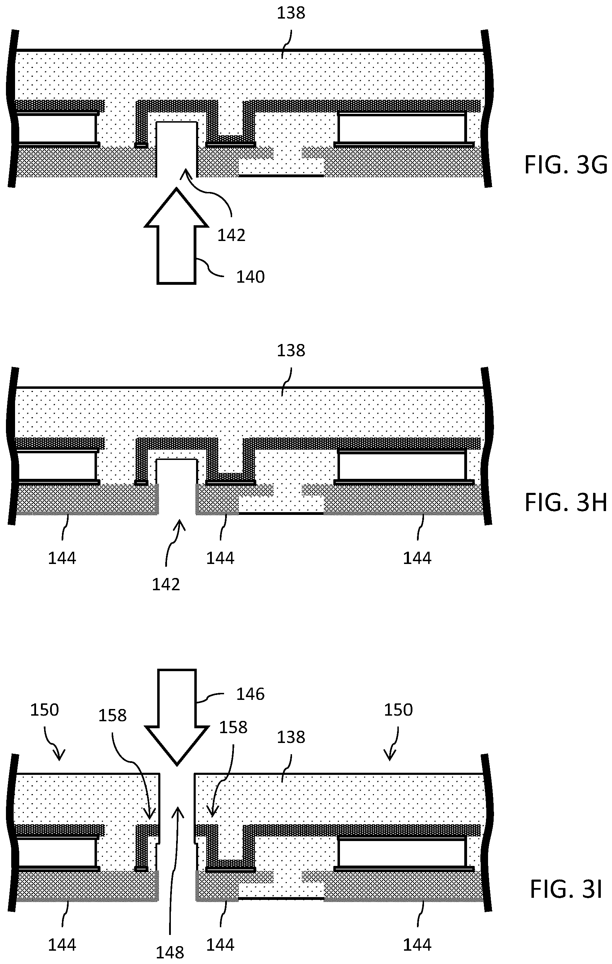

Figure 3G - a saw (schematically represented by arrow 140) is used to partially cut into the encapsulated assembly from a lower surface thereof to form a channel 142. This saw cut is aligned with the half-etched opening 120b and passes completely through the leadframe 112 to separate the die pad region 115 and lead region 116 of each frame portion 114. The depth of the channel 142 made by the saw cut is sufficient to remove a portion of the cured resin encapsulant material that is located between the first and second vertical legs of the bridge portion 128c of the metal clip 128 without severing the horizontal leg which extends between the first and second vertical legs. As the presence of the half-etched opening 120b is optional, it will be understood that in cases where the half-etched opening 120b is not present to assist with saw 140 alignment that other means must be used to ensure that the saw cut is accurately positioned to form channel 142 at the location between the first and second vertical legs of the bridge portion 128c of the metal clip 128.

Figure 3H - a plating process is then performed to plate a tin layer 144 on the exposed surfaces of the leadframe 112. These exposed surfaces would include, for example, the lower surfaces of the die pad region 115, the lower surfaces of the lead region 116 of each frame portion 114 of the leadframe 12, and the sidewalls of the die pad region 115 and lead region 116 at the channel 142.

It will be noted that the metal clips 128 provide electrical connections among and between all of the frame portions 114 of the etched leadframe 112. An advantage of this is that all frame portions 114 can be placed at the same electrical potential in connection with the performance of an electroplating process in the manufacturing step of Figure 3H to deposit the tin layer 144.

Figure 3I - a saw (schematically represented by arrow 146) is used to completely cut through the encapsulated assembly from an upper surface thereof and form separation opening 148. This saw cut is aligned with the location of the saw cut which formed the channel 142. This cutting operation effectuates a singulation of the encapsulated assembly into a plurality of power leadframe packages 150. The saw cut is made through the horizontal leg of the bridge portion 128c of the metal clip 128, and thus leaves opposed residual parts 158 of the bridge portion 128c with cut ends of the horizontal leg of the bridge portion 128c exposed at peripheral side surfaces of each power leadframe package 150. Figure 5D shows a top view (without the encapsulant present) of a portion of the leadframe 112 with attached integrated circuit dies 124 and mounted metal clips 128 at the stage of the manufacturing process shown in Figure 3I. A width of the saw cut performed by saw 146 is smaller than a width of the saw cut performed by saw 140.

Figure 4 shows a cross-sectional view of the power leadframe package 150. It will be noted that the flank area 154 of the leads 152 and die pad 153 for the power leadframe package presents a fully wettable flank portion 156 (covered by the tin layer 144). The entire sidewall surfaces for the package leads 152 and die pad 153 were exposed by the saw cut in the step shown in Figure 3G and as a result the electroplating process covered the entire sidewall surfaces with the tin layer 144. This power leadframe package 150 accordingly includes a fully-wettable sidewall for the package leads 152 and die pad 153. The cut ends of the horizontal leg of the bridge portion 128c which are exposed at peripheral side surfaces of each power leadframe package 150 provide a clear indication that the horizontal leg of the bridge portion 128c of the metal clip 128 was present during manufacturing and severed during the singulation process. The lateral offset of the peripheral sidewall of the package relative to the fully-wettable sidewall for the package leads 152 and die pad 153 provides a clear indication of the use of two separate cuts during manufacturing.

In the context of Figure 4, the included residual parts 158 are positioned (and exposed) at opposite peripheral side surfaces of the encapsulating body. One of the residual parts 158 is part of a (first) metal clip that is mounted to the integrated circuit die of the illustrated package 150 and the other of the residual parts 158 is part of a (second) metal clip that is mounted to the integrated circuit die another (not illustrated) illustrated package 150 (see, Figure 3I) severed from each other during the singulation process. The fully wettable sidewall for the package leads 152 and the fully wettable sidewall for die pad 153 are provided at the corresponding opposite peripheral side surfaces of the encapsulating body.

In a preferred embodiment, the integrated circuit die 124 is a power metal oxide semiconductor field effect transistor (MOSFET) and the one or more metal clips 128 included in the package 150 support a high current capacity associated with the source/drain region of the MOSFET. In particular, the opening 148 severed die pad region 115 provides a current conduction lead (die pad) for the drain terminal of the MOSFET and the opening 148 severed lead region 116 along with metal clip 128 provides a current conduction lead for the source terminal of the MOSFET. It will, of course, be understood that a lead structure of the leadframe 112 for the gate terminal (see Figure 6) would be present and that lead structure could, for example, be electrically connected to a gate bonding pad of the integrated circuit die 124 using convention wire bonding (like that shown in Figure 1C). Alternatively, a smaller (for example, narrower) metal clip 128 could be used for the electrical connection of the gate bonding pad to the lead structure of the leadframe 112 (as shown in Figure 6).

With reference to the perspective view shown in Figure 6, it will also be noted that clip 128 can include multiple chip mounting portions 128a, lead mounting portions 128b and bridge portions 128c. In this case, for example, the larger chip mounting portion 128a is configured for connection to a power transistor source/drain region of the integrated circuit die 124 while the smaller chip mounting portion 128a is configured for connection to a transistor gate region of the integrated circuit die 124.

Advantages of the method of Figures 3A-3I and the power leadframe package 150 of Figure 4 include, at least, the following: a) the entire sidewall surface for the package leads 152 is solderable and/or solder wettable; b) a stronger solder joint can be made between the power leadframe package 150 and a supporting substrate (such as a printed circuit board); c) the presence of side solder required for automated solder inspection is ensured; d) a simple electroplating process is supported for depositing the tin layer, and this is less expensive that the use of electroless plating; and e) there is an improved performance in terms of lead anchoring.

The invention is described by the appended claims.

## Claims

1. A method, comprising:
providing an etched leadframe that includes a plurality of frame portions, wherein the frame portions are separated from each other by spaces, and wherein each frame portion includes an intermediate region interposed between a lead region and a die pad region;
mounting an integrated circuit die to an upper surface of each frame portion at said die pad region;
mounting a chip mounting portion of a metal clip to each integrated circuit die, said metal clip further including a lead mounting portion mounted to the lead region of an adjacent frame portion, and said metal clip still further including a bridge portion extending over said intermediate region of said adjacent frame portion and mounted to the die pad region of said adjacent frame portion;
performing a first operation to cut through the frame portion of each etched leadframe at said intermediate region to separate the lead region and die pad region without severing the bridge portion of each metal clip;
plating a conductive layer on full sidewalls of the lead region and die pad region exposed by the first operation to cut; and
performing a second operation to cut through the bridge portion of each metal clip.

2. The method of claim 1, wherein performing the first operation to cut comprises sawing.

3. The method of claim 1, wherein performing the second operation to cut comprises sawing.

4. The method of claim 1, wherein plating the conductive layer comprises performing an electroplating.

5. The method of claim 4, wherein electroplating comprises applying a potential to the lead regions and die pad regions of all frame portions of the leadframe through an electrical connection provided by the metal clips.

6. The method of claim 1, wherein plating the conductive layer further comprises plating the conductive layer on bottom surfaces of the lead regions and die pad regions of all frame portions of the leadframe.

7. The method of claim 1, further comprising encapsulating an assembly formed by the etched leadframe, mounted integrated circuits and mounted metal clips in an encapsulating material forming an encapsulating body.

8. The method of claim 7, wherein performing the first operation to cut further cuts through a portion of the encapsulating material forming the encapsulating body that is located between the bridge portion of each metal clip and the intermediate region of the frame portions of the leadframe.

9. The method of claim 8, wherein performing the first operation to cut comprises applying the cut to a lower surface of the encapsulating body at the intermediate region.

10. The method of claim 7, wherein performing the second operation to cut further cuts through a portion of the encapsulating material forming the encapsulating body that is located between the bridge portion of each metal clip and an upper surface of the encapsulating body.

11. The method of claim 10, wherein performing the second operation to cut comprises applying the cut to the upper surface of the encapsulating body.

12. The method of claim 1, wherein providing the etched leadframe further comprises providing a channel at a lower surface of each frame portion at the intermediate region.

13. The method of claim 12, wherein performing the first operation to cut comprises aligning the first operation to cut with the channel at the lower surface of each frame portion.

14. A power leadframe integrated circuit package, comprising:
a leadframe including a lead region and a die pad region separated by a space;
an integrated circuit die mounted to an upper surface of the die pad region;
a first metal clip having a chip mounting portion mounted to the integrated circuit die, said first metal clip further including a lead mounting portion mounted to the lead region and a first residual bridge portion;
a second metal clip including a second residual bridge portion mounted to the die pad region;
an encapsulating body encapsulating the leadframe, the integrated circuit die and the first and second metal clips;
wherein said encapsulating body has a first peripheral sidewall at which an end of said first residual bridge portion is exposed and has a second peripheral sidewall, opposite said first peripheral sidewall, at which an end of said second residual bridge portion is exposed;
wherein a sidewall of the lead region is exposed at said first peripheral sidewall of the encapsulating body, and wherein a sidewall of the die pad region is exposed at said second peripheral sidewall of the encapsulating body; and
a plating layer on all of said sidewall of the lead region and all of said sidewall of the die pad region.

15. The power leadframe integrated circuit package of claim 14, wherein said integrated circuit die comprises a power metal oxide semiconductor field effect transistor (MOSFET) and wherein said first metal clip provides a high current capacity associated with a source region or drain region of the MOSFET.

16. The power leadframe integrated circuit package of claim 14, wherein the plating layer is a tin layer.

17. The power leadframe integrated circuit package of claim 14, wherein the plating layer further extends on lower surfaces of the lead region and die pad region.

18. The power leadframe integrated circuit package of claim 14, wherein the second residual bridge portion is a singulation severed part of the first metal clip for another power leadframe integrated circuit package.

19. The power leadframe integrated circuit package of claim 14, wherein the first residual bridge portion is a singulation severed part of the second metal clip for another power leadframe integrated circuit package.

## Patentansprüche

1. Verfahren, das Folgendes umfasst:
Bereitstellen eines geätzten Anschlussrahmens, der eine Vielzahl von Rahmenabschnitten enthält, wobei die Rahmenabschnitte voneinander durch Lücken getrennt sind, und wobei jeder Rahmenabschnitt einen Zwischenbereich enthält, der zwischen einem Anschlussbereich und einem Die-Kontaktstellenbereich eingefügt ist;
Montieren eines integrierten Schaltungs-Dies an einer oberen Oberfläche jedes Rahmenabschnitts in dem Die-Kontaktstellenbereich;
Montieren eines Chipmontageabschnitts eines Metallclips an jedem integrierten Schaltungs-Die, wobei der Metallclip ferner einen Anschlussmontageabschnitt enthält, der an dem Anschlussbereich eines benachbarten Rahmenabschnitts montiert ist, und wobei der Metallclip ferner einen Brückenabschnitt enthält, der sich über den Zwischenbereich des benachbarten Rahmenabschnitts erstreckt und an dem Die-Kontaktstellenbereich des benachbarten Rahmenabschnitts montiert ist;
Durchführen eines ersten Vorgangs zum Durchschneiden des Rahmenabschnitts jedes geätzten Anschlussrahmens an dem Zwischenbereich, um den Anschlussbereich und den Die-Kontaktstellenbereich zu trennen, ohne den Brückenabschnitt jedes Metallclips zu trennen;
Plattieren einer leitfähigen Schicht auf vollen Seitenwänden des Anschlussbereichs und des Die-Kontaktstellenbereichs, die durch den ersten Schneidevorgang freigelegt wurden; und
Durchführen eines zweiten Vorgangs zum Durchschneiden des Brückenabschnitts jedes Metallclips.

2. Verfahren nach Anspruch 1, wobei das Durchführen des ersten Schneidevorgangs das Sägen umfasst.

3. Verfahren nach Anspruch 1, wobei das Durchführen des zweiten Schneidevorgangs das Sägen umfasst.

4. Verfahren nach Anspruch 1, wobei das Plattieren der leitfähigen Schicht das Durchführen einer Galvanisierung umfasst.

5. Verfahren nach Anspruch 4, wobei das Galvanisieren das Anlegen eines Potenzials an die Anschlussbereiche und die Die-Kontaktbereiche aller Rahmenabschnitte des Anschlussrahmens durch eine von den Metallclips bereitgestellte elektrische Verbindung umfasst.

6. Verfahren nach Anspruch 1, wobei das Plattieren der leitfähigen Schicht ferner das Plattieren der leitfähigen Schicht auf den Bodenflächen der Anschlussbereiche und Die-Kontaktstellenbereiche aller Rahmenabschnitte des Anschlussrahmens umfasst.

7. Verfahren nach Anspruch 1, ferner umfassend das Einkapseln einer Baugruppen, die durch den geätzten Anschlussrahmen, montierte integrierte Schaltungen und montierte Metallclips gebildet wird, in einem Einkapselungsmaterial, das einen Einkapselungskörper bildet.

8. Verfahren nach Anspruch 7, wobei beim Durchführen des ersten Schneidevorgangs weitere Schnitte durch einen den Einkapselungskörper bildenden Abschnitt des Einkapselungsmaterials erfolgen, der sich zwischen dem Brückenabschnitt jedes Metallclips und dem Zwischenbereich der Rahmenabschnitte des Anschlussrahmens befindet.

9. Verfahren nach Anspruch 8, wobei das Durchführen des ersten Schneidevorgangs das Anwenden des Schnitts an einer unteren Oberfläche des Einkapselungskörpers im Zwischenbereich umfasst.

10. Verfahren nach Anspruch 7, wobei das Durchführen des zweiten Schneidevorgangs weitere Schnitte durch einen den Einkapselungskörper bildenden Abschnitt des Einkapselungsmaterials erfolgt, der sich zwischen dem Brückenabschnitt jedes Metallclips und einer oberen Oberfläche des Einkapselungskörpers befindet.

11. Verfahren nach Anspruch 10, wobei das Durchführen des zweiten Schneidevorgangs das Anwenden des Schnitts an der oberen Oberfläche des Einkapselungskörpers umfasst.

12. Verfahren nach Anspruch 1, wobei das Bereitstellen des geätzten Anschlussrahmens ferner das Bereitstellen eines Kanals an einer unteren Oberfläche jedes Rahmenabschnitts im Zwischenbereich umfasst.

13. Verfahren nach Anspruch 12, wobei das Durchführen des ersten Schneidevorgang das Ausrichten des ersten Schneidevorgangs mit dem Kanal an der unteren Oberfläche jedes Rahmenabschnitts umfasst.

14. Integriertes Schaltungsgehäuse mit Leistungs-Anschlussrahmen, umfassend:
einen Anschlussrahmen, der einen Anschlussbereich und einen durch eine Lücke getrennten Die-Kontaktstellenbereich umfasst;
einen integrierten Schaltungs-Die, der an einer oberen Oberfläche des Die-Kontaktstellenbereichs montiert ist;
einen ersten Metallclip mit einem Chipmontageabschnitt, der an dem integrierten Schaltungs-Die montiert ist, wobei der erste Metallclip ferner einen Anschlussmontageabschnitt, der an dem Anschlussbereich montiert ist, und einen ersten Restbrückenabschnitt enthält;
einen zweiten Metallclip, der einen zweiten Restbrückenabschnitt enthält, der am Die-Kontaktstellenbereich montiert ist;
einen Einkapselungskörper, der den Anschlussrahmen, den integrierten Schaltungs-Die und den ersten und den zweiten Metallclip einkapselt;
wobei der Einkapselungskörper eine erste periphere Seitenwand, an der ein Ende des ersten Restbrückenabschnitts freiliegt, und eine der ersten peripheren Seitenwand gegenüberliegende zweite periphere Seitenwand aufweist, an der ein Ende des zweiten Restbrückenabschnitts freiliegt;
wobei eine Seitenwand des Anschlussbereichs an der ersten peripheren Seitenwand des Einkapselungskörpers freiliegt, und wobei eine Seitenwand des Die-Kontaktstellenbereichs an der zweiten peripheren Seitenwand des Einkapselungskörpers freiliegt; und
eine Plattierungsschicht auf der gesamten Seitenwand des Anschlussbereichs und der gesamten Seitenwand des Die-Kontaktstellenbereichs.

15. Integriertes Schaltungsgehäuse mit Leistungs-Anschlussrahmen nach Anspruch 14, wobei der integrierte Schaltungs-Die einen Leistungs-Metalloxid-Halbleiter-Feldeffekttransistor (MOSFET) umfasst und wobei der erste Metallclip eine hohe Stromkapazität bereitstellt, die mit einem Source-Bereich oder Drain-Bereich des MOSFET verbunden ist.

16. Integriertes Schaltungsgehäuse mit Leistungs-Anschlussrahmen nach Anspruch 14, wobei die Plattierungsschicht eine Zinnschicht ist.

17. Integriertes Schaltungsgehäuse mit Leistungs-Anschlussrahmen nach Anspruch 14, wobei sich die Plattierungsschicht weiter auf untere Oberflächen des Anschlussbereichs und des Die-Kontaktstellenbereichs erstreckt.

18. Integriertes Schaltungsgehäuse mit Leistungs-Anschlussrahmen nach Anspruch 14, wobei der zweite Restbrückenabschnitt ein abgetrennter Vereinzelungsteil des ersten Metallclips für ein weiteres integriertes Schaltungsgehäuse mit Leistungs-Anschlussrahmen ist.

19. Integriertes Schaltungsgehäuse mit Leistungs-Anschlussrahmen nach Anspruch 14, wobei der erste Restbrückenabschnitt ein abgetrennter Vereinzelungsteil des zweiten Metallclips für ein weiteres integriertes Schaltungsgehäuse mit Leistungs-Anschlussrahmen ist.

## Revendications

1. Procédé, comprenant :
la fourniture d'une grille de connexion gravée qui comporte une pluralité de parties de grille, dans lequel les parties de grille sont séparées les unes des autres par des espaces, et dans lequel chaque partie de grille comporte une région intermédiaire interposée entre une région de broche de raccordement et une région de pastille de puce ;
le montage d'un dé de circuit intégré sur une surface supérieure de chaque partie de grille au niveau de ladite région de pastille de puce ;
le montage d'une partie de montage de puce d'un clip métallique sur chaque dé de circuit intégré, ledit clip métallique comportant en outre une partie de montage de broche de raccordement montée sur la région de broche de raccordement d'une partie de grille adjacente, et ledit clip métallique comportant en outre une partie de pont s'étendant sur ladite région intermédiaire de ladite partie de grille adjacente et montée sur la région de pastille de dé de ladite partie de grille adjacente ;
la réalisation d'une première opération de découpe à travers la partie de grille de chaque grille de connexion gravée au niveau de ladite région intermédiaire pour séparer la région de broche de raccordement et la région de pastille de dé sans sectionner la partie de pont de chaque clip métallique ;
le placage d'une couche conductrice sur des parois latérales complètes de la région de broche de raccordement et de la région de pastille de dé exposées par la première opération de découpe ; et
la réalisation d'une deuxième opération de découpe à travers la partie de pont de chaque clip métallique.

2. Procédé selon la revendication 1, dans lequel la réalisation de la première opération de découpe comprend le sciage.

3. Procédé selon la revendication 1, dans lequel la réalisation de la deuxième opération de découpe comprend le sciage.

4. Procédé selon la revendication 1, dans lequel le placage de la couche conductrice comprend la réalisation d'un électroplacage.

5. Procédé selon la revendication 4, dans lequel l'électroplacage comprend l'application d'un potentiel aux régions de connexion et aux régions de pastille de dé de toutes les parties de grille de la grille de connexion par le biais d'une connexion électrique fournie par les clips métalliques.

6. Procédé selon la revendication 1, dans lequel le placage de la couche conductrice comprend en outre le placage de la couche conductrice sur des surfaces inférieures des régions de connexion et des régions de pastille de dé de toutes les parties de grille de la grille de connexion.

7. Procédé selon la revendication 1, comprenant en outre l'encapsulation d'un ensemble formé par la grille de connexion gravée, des circuits intégrés montés et des clips métalliques montés dans un matériau d'encapsulation formant un corps d'encapsulation.

8. Procédé selon la revendication 7, dans lequel la réalisation de la première opération de découpe effectue en outre une découpe à travers une partie du matériau d'encapsulation formant le corps d'encapsulation qui est située entre la partie de pont de chaque clip métallique et la région intermédiaire des parties de grille de la grille de connexion.

9. Procédé selon la revendication 8, dans lequel la réalisation de la première opération de découpe comprend l'application de la découpe sur une surface inférieure du corps d'encapsulation au niveau de la région intermédiaire.

10. Procédé selon la revendication 7, dans lequel la réalisation de la deuxième opération de découpe effectue en outre une découpe à travers une partie du matériau d'encapsulation formant le corps d'encapsulation qui est située entre la partie de pont de chaque clip métallique et une surface supérieure du corps d'encapsulation.

11. Procédé selon la revendication 10, dans lequel la réalisation de la deuxième opération de découpe comprend l'application de la découpe sur la surface supérieure du corps d'encapsulation.

12. Procédé selon la revendication 1, dans lequel la fourniture de la grille de connexion gravée comprend en outre la fourniture d'un canal à une surface inférieure de chaque partie de grille au niveau de la région intermédiaire.

13. Procédé selon la revendication 12, dans lequel la réalisation de la première opération de découpe comprend l'alignement de la première opération de découpe avec le canal à la surface inférieure de chaque partie de grille.

14. Boîtier de circuit intégré de grille de connexion de puissance, comprenant :
une grille de connexion comportant une région de broche de raccordement et une région de pastille de dé séparées par un espace ;
une puce de circuit intégré montée sur une surface supérieure de la région de pastille de dé ;
un premier clip métallique ayant une partie de montage de puce montée sur le dé de circuit intégré, ledit premier clip métallique comportant en outre une partie de montage de broche de raccordement montée sur la région de broche de raccordement et une première partie de pont résiduelle ;
un deuxième clip métallique comportant une deuxième partie de pont résiduelle montée sur la région de pastille de dé ;
un corps d'encapsulation encapsulant la grille de connexion, le dé de circuit intégré et les premier et deuxième clips métalliques ;
dans lequel ledit corps d'encapsulation présente une première paroi latérale périphérique au niveau de laquelle une extrémité de ladite première partie de pont résiduelle est exposée et présente une deuxième paroi latérale périphérique, opposée à ladite première paroi latérale périphérique, au niveau de laquelle une extrémité de ladite deuxième partie de pont résiduelle est exposée ;
dans lequel une paroi latérale de la région de broche de raccordement est exposée au niveau de ladite première paroi latérale périphérique du corps d'encapsulation, et dans lequel une paroi latérale de la région de pastille de dé est exposée au niveau de ladite deuxième paroi latérale périphérique du corps d'encapsulation ; et
une couche de placage sur l'ensemble de ladite paroi latérale de la région de broche de raccordement et de l'ensemble de ladite paroi latérale de la région de pastille de dé.

15. Boîtier de circuit intégré de grille de connexion de puissance selon la revendication 14, dans lequel ledit dé de circuit intégré comprend un transistor à effet de champ à semi-conducteur à oxyde métallique (MOSFET) de puissance et dans lequel ledit premier clip métallique fournit une capacité de courant élevée associée à une région de source ou région de drain du MOSFET.

16. Boîtier de circuit intégré de grille de connexion de puissance selon la revendication 14, dans lequel la couche de placage est une couche d'étain.

17. Boîtier de circuit intégré de grille de connexion de puissance selon la revendication 14, dans lequel la couche de placage s'étend en outre sur des surfaces inférieures de la région de broche de raccordement et de la région de pastille de dé.

18. Boîtier de circuit intégré de grille de connexion de puissance selon la revendication 14, dans lequel la deuxième partie de pont résiduelle est une partie sectionnée de séparation du premier clip métallique pour un autre boîtier de circuit intégré de grille de connexion de puissance.

19. Boîtier de circuit intégré de grille de connexion de puissance selon la revendication 14, dans lequel la première partie de pont résiduelle est une partie sectionnée de séparation du deuxième clip métallique pour un autre boîtier de circuit intégré de grille de connexion de puissance.
